# EUROPÄISCHE PATENTSCHRIFT

(11) **EP 0 359 326 B1**
(45) Veröffentlichungstag und Bekanntmachung des Hinweises auf die Patenterteilung: **09.02.1994**
(21) Anmeldenummer: 89202280.7
(22) Anmeldetag: 11.09.1989
(51) Int. Cl.: G01R 19/22, H03D 1/18

(54) **Vollweg-Gleichrichterschaltung**
Full-wave rectifier circuit
Circuit redresseur à deux alternances

(30) Priorität: 16.09.1988 DE 3831454
(43) Veröffentlichungstag der Anmeldung: 21.03.1990
(73) Patentinhaber: Philips Patentverwaltung GmbH, 22335 Hamburg (DE); Philips Electronics N.V., 5621 BA Eindhoven (NL)
(72) Erfinder: Siebörger, Günther, D-2000 Hamburg-Schenefeld (DE)
(74) Vertreter: Hartmann, Heinrich, Dipl.-Ing.

(56) Entgegenhaltungen:
- GB-A- 2 046 453
- GB-A- 2 084 826
- GB-A- 2 120 028
- GB-A- 2 148 062
- IEE PROCEEDINGS, Band 134, Nr. 1, Teil G, Februar 1987, Seiten 7-14, Stevenage, GB; C. TOUMAZOU et al.: "Wide-band precision rectification"

## Beschreibung

Die Erfindung betrifft eine Vollweg-Gleichrichterschaltung mit einem Signaleingang, der mit dem Signalausgang über eine Gleichrichterstufe gekoppelt ist, die eine bei der einen Halbschwingung vom Eingangssignalstrom durchflossene Halbleiterstrecke und einen bei der anderen Halbschwingung den Eingangsstrom zum Signalausgang spiegelnden Stromspiegel umfaßt, mit einem Differenzverstärker, dessen einer Eingang mit dem Eingang der Gleichrichterstufe gekoppelt ist und dessen Ausgang über eine Treiberstufe im Sinne einer Gegenkopplung gekoppelt ist, sowie mit einer Stromquelle zur Lieferung der Versorgungsströme für die Treiberstufe und den Stromspiegel.

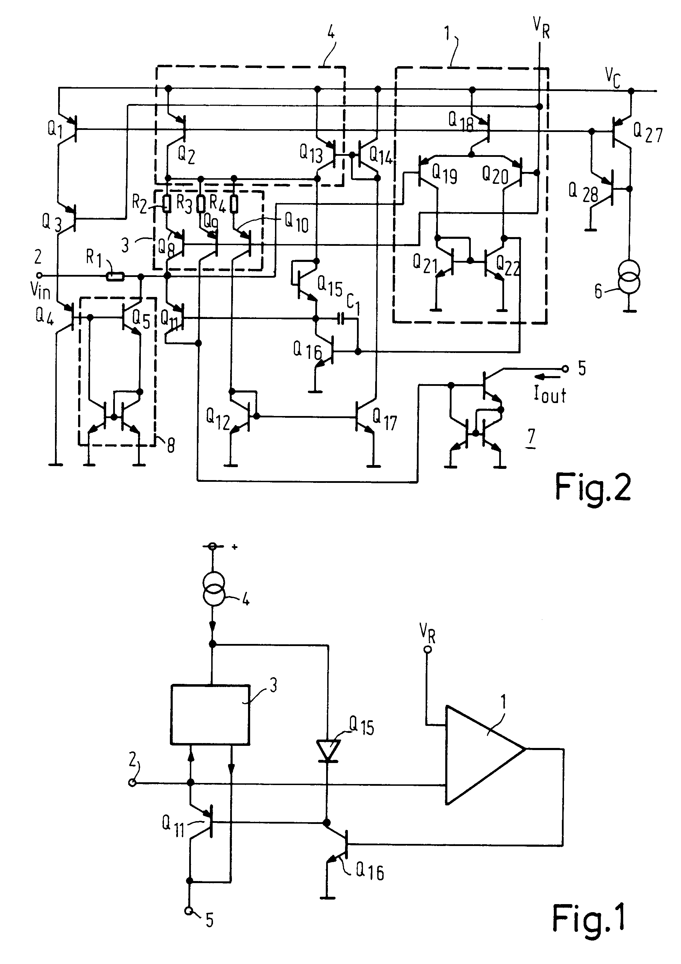

Eine solche Vollweg-Gleichrichterschaltung ist Teil der bekannten Integrierten Schaltung TEA 0652. Fig. 1 zeigt ein Prinzipschaltbild dieser Schaltung. Dabei ist mit 1 ein Differenzverstärker bezeichnet, dessen einer Eingang an eine Referenzspannung V_{R} und dessen Ausgang mit dem Eingang einer Treiberstufe verbunden ist. Die Treiberstufe umfaßt einen npn-Transistor Q₁₆, dessen Emitter mit dem negativen Versorgungsspannungsanschluß verbunden ist und dessen Kollektor mit der Basis eines Transistors Q₁₁ verbunden ist, dessen Emitter im Sinne einer Gegenkopplung an einen weiteren Eingang des Differenzverstärkers 1 angeschlossen ist. Diesem Eingang bzw. dem Emitter des Transistors Q₁₁ wird von einem Signaleingang 2 der gleichzurichtende Signalstrom zugeführt. Die Gleichrichterstufe umfaßt außer dem Transistor Q₁₁ einen Stromspiegel 3, dessen Eingang mit dem Eingang 2 verbunden ist und dessen Ausgang mit dem Kollektor des Transistors Q₁₁ verbunden ist, der den Gleichrichterausgang bildet bzw. damit gekoppelt ist.

Der Versorgungsstrom für den Stromspiegel 3 wird von einer Gleichstromquelle geliefert, die über eine Diode Q₁₅ mit dem Kollektor des Transistors Q₁₆ verbunden ist. Somit liefert die Gleichstromquelle sowohl den Versorgungsstrom für den Stromspiegel 3 (dieser Versorgungsstrom entspricht der Summe der in den Stromspiegel hinein- bzw. daraus herausfließenden Ströme) als auch den Versorgungsstrom für die Treiberstufe Q₁₅, Q₁₆.

Die bekannte Schaltung arbeitet wie folgt:
Bei einer positiven Polarität des am Eingang 2 zugeführten Signalstromes fließt der Signalstrom über die Kollektor-Emitterstrecke des Transistors Q₁₁ zum Gleichrichterausgang 5 der Schaltung. Der Stromspiegel 3 führt bei dieser Polarität des Eingangsstroms keinen Strom. Bei einer negativen Polarität fließt der Signalstrom über den Eingang des Stromspiegels 3 und die Stromquelle 4 zu der positiven Versorgungsspannungsklemme und bewirkt, daß vom Ausgang des Stromspiegels 3 ein Strom zu dem Ausgang 5 fließt, der die gleiche Polarität hat wie bei der positiven Halbwelle. Somit erscheinen bei wechselnder Strompolarität am Eingang 2 am Ausgang 5 Stromhalbwellen mit der gleichen Polarität, was einer Vollweg-Gleichrichtung entspricht.

Der von der Stromquelle 4 gelieferte Strom muß zumindest etwas größer sein als der Strom, der vom Stromspiegel 3 bei einem Signalstrom mit negativer Polarität und größtmöglicher Amplitude fließt, damit die Treiberstufe Q₁₅, Q₁₆ nicht stromlos wird und die durch den Differenzverstärker 1 die Treiberstufe und den Transistor Q₁₁ gebildete Gegenkopplungsschleife wirksam bleibt, durch die erreicht wird, daß das Potential an den beiden Differenzverstärker-Eingängen auf den gleichen Wert (d. h. auf die Referenzspannung V_{R} gezogen wird. Bei einer positiven Polarität des Signalstrom fließt der gesamte, von der Gleichstromquelle 4 gelieferte Strom über die Treiberstufe Q₁₅ und Q₁₆. Er ist dann also wesentlich größer als bei der negativen Halbwelle und erfordert einen entsprechend großen Basisstrom. Ein solcher Basisstrom setzt einen Spannungsoffset am Eingang des Differenzverstärkers voraus, d. h. bei einer positiven Polarität des Eingangsstromes können die Potentiale an den beiden Eingängen des Differenzverstärkers nicht mehr identisch sein. Dieser Spannungsoffset führt dazu, daß insbesondere bei kleinen Signalströmen mit gleich großen Stromhalbschwingungen am Eingang 2 am Ausgang 5 der Gleichrichterstufe ungleich große Halbschwingungen (mit gleicher Polarität) auftreten. Diese Verzerrung ist unerwünscht, insbesondere wenn das gleichgerichtete Signal als Regelsignal in einer schnell reagierenden Regelschaltung dient.

Aufgabe der vorliegenden Erfindung ist es, einen Vollweg-Gleichrichter der eingangs genannten Art zu schaffen, bei dem dieser Fehler zumindest verringert ist. Diese Aufgabe wird erfindungsgemäß dadurch gelöst, daß die Stromquelle als steuerbare Stromquelle ausgebildet ist, die von einem aus dem Ausgangsstrom des ersten Stromspiegels abgeleiteten Strom derart gesteuert wird, daß der Versorgungsstrom des Stromspiegels der durch die Steuerung bewirkten Stromänderung der Stromquelle entspricht.

Bei der Erfindung wird der Versorgungsstrom also von einer steuerbaren Stromquelle geliefert, die so gesteuert ist, daß die durch die Steuerung bewirkte Stromänderung gerade dem jeweils für den Stromspiegel 3 benötigten, von der Eingangssignalamplitude abhängigen Versorgungsstrom entspricht. Über die Treiberstufe fließt dann ein konstanter Gleichstrom, der sich so niedrig einstellen läßt, daß die dafür erforderlichen Offset-Spannungen am Eingang des Differenzverstärkers 1 zumindest erheblich verringert, wenn nicht gar kompensiert werden.

Die steuerbare Stromquelle muß den konstanten Versorgungsstrom für die Treiberstufe und den variablen Versorgungsstrom für den Stromspiegel liefern. Dies kann in weiterer Ausgestaltung der Erfindung besonders einfach dadurch erreicht werden, daß die steuerbare Stromquelle eine Konstant-Stromquelle umfaßt und den Ausgang eines zweiten Stromspiegels, dessen Eingang mit dem Ausgang eines dritten Stromspiegels gekoppelt ist, dessen Eingang an den Ausgang des ersten Stromspiegels angeschlossen ist. Der Ausgang des zweiten Stromspiegels liefert also den Versorgungsstrom für den ersten Stromspiegel, während die Konstant-Stromquelle den Versorgungsstrom für die Treiberstufe liefert.

Wenn der Differenzverstärker bipolare Eingangstransistoren enthält, deren Basen den Eingang des Differenzverstärkers bilden, ist der Eingangsstrom des Differenzverstärkers nicht vernachlässigbar und kann einen zusätzlichen Spannungsoffset erzeugen. Dieser läßt sich nach einer Weiterbildung der Erfindung dadurch vermeiden, daß der Differenzverstärker bipolare Eingangstransistoren enthält, deren Basen die Eingänge des Differenzverstärkers bilden, und daß die Basis des Eingangstransistors, die mit dem Schaltungseingang gekoppelt ist, mit dem Ausgang eines vierten Stromspiegels gekoppelt ist, dessen Eingang mit der Basis eines Transistors gekoppelt ist, dessen Emitterstrom proportional dem Emitterstrom des Eingangstransistors ist. Der vierte Stromspiegel liefert dabei gerade den Basisstrom für den Eingangstransistor, so daß der erwähnte Spannungsoffset vermieden wird.

Die Erfindung wird nachstehend anhand der Zeichnungen näher erläutert. Es zeigen:
Fig. 1 ein Blockschaltbild der bekannten Schaltung und
Fig. 2 ein Detailschaltbild einer erfindungsgemäßen Ausführungsform.

In Fig. 2 sind die in ihrer Funktion mit den Komponenten in Fig. 1 im wesentlichen übereinstimmenden Komponenten mit den gleichen Bezugszeichen bezeichnet.

Der Differenzverstärker 1 wird durch eine bei Operationsverstärkern übliche Eingangsstufe gebildet. Sie enthält einen pnp-Transistor Q₁₈, dessen Emitter mit der positiven Versorgungsspannung verbunden ist und dessen Kollektor an die miteinander verbundenen Emitter zweier Transistoren Q₁₉ und Q₂₀ angeschlossen ist. Der Basis-Emitterstrecke des Transistors Q₁₈ ist die Basis-Emitterstrecke eines Transistors Q₂₇ parallelgeschaltet, dessen Kollektor-Emitterstrecke mittels eines Transistors Q₂₈ und einer Gleichstromquelle 6 mit einem Gleichstrom von z. B. 10 µA beaufschlagt wird. Bei gleicher Transistor-Geometrie führt der Transistor Q₁₈ denselben Gleichstrom, der sich je zur Hälfte auf die beiden Transistoren Q₁₉ und Q₂₀ aufteilt. Die Basis des Transistros Q₂₀ ist an eine Referenzspannung V_{R} angeschlossen, die beispielsweise der halben Versorgungsspannung entspricht. Die Basis des Transistors Q₁₉ ist über einen Widerstand R₁, der einige Kohm groß sein kann, mit dem Eingang des Vollweg-Gleichrichters 2 verbunden, an dem eine gleichzurichtende Signalspannung anliegt. Die Kollektoren der Transistoren Q₁₉ und Q₂₀ sind mit dem Eingang bzw. mit dem Ausgang eines Stromspiegels verbunden, der die npn-Transistoren Q₂₁ und Q₂₂ umfaßt.

Der durch den Verbindungspunkt der Kollektoren der Transistoren Q₂₀ und Q₂₂ gebildete Ausgang des Differenzverstärkers 1 ist mit der Basis des Transistors Q₁₆ der Treiberstufe verbunden, dessen Kollektor-Basisstrecke durch einen Kondensator C₁ von z. B. 15 pF überbrückt ist, um die Stabilität der Schleife zu gewährleisten. Wenn der Basisstrom des Treibertransistors Q₁₆ doppelt so groß ist wie der Basisstrom der Transistoren Q₂₁ oder Q₂₂, wird der Basis-Gleichstrom für die Stufe Q₁₆ gerade dann erzeugt, wenn die Basisanschlüsse der Transistoren Q₁₉ und Q₂₀ auf dem gleichen Potential liegen.

Der Transistor Q₁₁, dessen Basis mit dem Kollektor von Q₁₆ und dessen Emitter mit der Basis des Transistors Q₁₉ verbunden ist, vollendet eine Gegenkopplungsschleife, durch die erzwungen wird, daß das Potential an der Basis von Q₁₉ dem Potential an der Basis von Q₂₀ folgt. Der Verbindungspunkt des Emitters des Transistors Q₁₁ mit der Basis von Q₁₉ wirkt daher als virtueller Nullpunkt, d. h. so, als wäre dort eine (niederohmige) Gleichspannungsquelle mit der Spannung V_{R} angeschlossen. Infolgedessen wird die Signalspannung am Eingang 2 in einen Signalstrom umgesetzt.

Der Stromspiegel 3 enthält einen pnp-Transistor Q₈, dessen Kollektor mit dem Emitter von Q₁₁ verbunden ist und dessen Emitter über einen Widerstand R₂ von z. B. 4,7 k an den Ausgang der Stromquelle 4 angeschlossen ist. Die Basis des Transistors Q₈ ist an die Referenzspannung VR angeschlossen und an die Basis eines weiteren pnp-Transistors Q₉ mit der gleichen Transistor-Geometrie, dessen Emitter über einen Widerstand R₃ mit der gleichen Größe wie R₂ an den Ausgang der Stroquelle angeschlossen ist. Der Kollektor des Transistors Q₉ ist mit dem Kollektor des Transistors Q₁₁ verbunden, und der gemeinsame Verbindungspunkt ist mit dem Eingang eines Stromspiegels 7 verbunden, dessen Ausgang zugleich den Vollweg-Gleichrichterausgang bildet.

Bei einer positiven Halbwelle (in bezug auf die Referenzspannung V_{R}) der Signalspannung am Eingang 2 ist der Transistor Q₁₁ leitend und führt den über den Widerstand R₁ fließenden Strom zum Stromspiegel 7. Die Diode Q₁₅ zieht dabei das Potential am Ausgang der Stromquelle 4 so weit nach unten, daß die Transistoren Q₈ und Q₉ bei der positiven Halbschwingung gesperrt sind.

Bei der negativen Halbschwingung der Signalspannung am Eingang verändert sich das Potential am Ausgang der Stromquelle 4 gerade so weit, daß der gesamte, über den Widerstand R₁ fließende Signalstrom über den Transistor Q₈ zur Stromquelle 4 fließen kann. Dies hat zur Folge, daß über den Transistor Q₉ ein Strom von gleicher Größe zum Stromspiegel 7 fließt. Bei der negativen Halbwelle fließt also der Eingangsstrom in die Einheit 3 hinein, und ein gleich großer Strom fließt aus ihr heraus. Die Einheit 3 wirkt also in Verbindung mit der Stromquelle 4 und der übrigen sie umgebenden Schaltung wie ein Stromspiegel. Sie wird daher als Stromspiegel bezeichnet, obwohl sie - für sich allein betrachtet - kein üblicher Stromspiegel ist.

Die Stromquelle 4 enthält einen pnp-Transistor Q₂, dessen Basis-Emitterstrecke derjenigen des Transistors Q₁₈ parallelgeschaltet ist. Der Kollektor des Transistors Q₂ ist mit dem Ausgang der Stromquelle verbunden. Wenn die Transistoren Q₂ und Q₁₈ die gleiche Transistor-Geometrie haben, liefert der Transistor Q₂ einen Gleichstrom, der dem vom Transistor Q₁₈ gelieferten Gleichstrom entspricht und doppelt so groß ist wie die Gleichströme durch die Transistoren Q₁₉ und Q₂₀.

Die Stromquelle 4 enthält außerdem einen pnp-Transistor Q₁₃, dessen Emitter mit der positiven Speisespannung verbunden ist und dessen Kollektor an den Ausgang der Stromquelle angeschlossen ist. Die Basis des Transistors Q₁₃ wird so gesteuert, daß dieser gerade den Versorgungsstrom für den Stromspiegel 3 liefern kann. Zu diesem Zweck ist der Basis-Emitterstrecke des Transistors Q₁₃ die Basis-Emitterstrecke eines als Diode geschalteten pnp-Transistors Q₁₄ parallelgeschaltet, so daß die Transistoren Q₁₃ und Q₁₄ einen Stromspiegel bilden, dessen Ausgang mit dem Ausgang der Stromquelle 4 verbunden ist und dessen Eingang mit dem Ausgang eines weiteren Stromspiegels verbunden ist, der durch die npn-Transistoren Q₁₂ und Q₁₇ gebildet wird. Der Eingang dieses weiteren Stromspiegels, d. h. der als Diode geschaltete Transistor Q₁₂, ist mit dem Kollektor eines pnp-Transistors Q₁₀ verbunden, dessen Basis mit den Basen der Transistoren Q₈ und Q₉ verbunden ist und dessen Emitter über einen Widerstand R₄, der die gleiche Größe hat wie die Widerstände R₂ und R₃, mit dem Ausgang der Stromquelle 4 verbunden ist. Der Transistor Q₁₀ bildet also einen zweiten Ausgang des Stromspiegels 3.

Die Stromquelle 4 wird in folgender Weise gesteuert:
Bei einer positiven Spannungshalbwelle am Eingang 2 bleiben alle Transistoren im Stromspiegel 3 stromlos. Infolgedessen führt auch der Transistor Q₁₃ keinen Strom, und lediglich der Transistor Q₂ führt einen Gleichstrom, der vollständig über die Treiberstufe Q₁₆, Q₁₅ geführt wird und der gerade so groß ist (doppelt so groß wie der Gleichstrom durch einen der Transistoren Q₁₉ oder Q₂₀), daß der Differenzverstärker 1 diesen Strom ohne Spannungsoffset liefern kann. Die Potentiale an den beiden Eingängen des Differenzverstärkers sind dann also identisch.

Bei einer negativen Signalspannungshalbwelle am Eingang 2 fließt durch den Transistor Q₈ des Stromspiegels der gesamte Signalstrom. Dieser beträgt bei einem Eingangssignal von 1 V oder mehr mehr als 200 µA und ist daher wesentlich größer als der Gleichstrom, den der Transistor Q₂ liefert (im Beispiel 10 µA). Der Versorgungsstrom des Stromspiegels ist dabei dreimal so groß wie der Strom durch den Transistor Q₈, weil die Transistoren Q₉ und Q₁₀ den gleichen Strom führen wie der Transistor Q₈. Zu diesem Zweck ist das Stromspiegel-Verhältnis eines der Stromspiegel Q₁₂, Q₁₇ oder Q₁₃, Q₁₄ vorzugsweise das des Stromspiegels Q₁₂, Q₁₇ 1 : 3, d. h. der Transistor Q₁₇ liefert einen Strom, der dreimal so groß ist wie der Strom, der in den Transistor Q₁₂ hinein fließt, was in bekannter Weise durch geeignete Wahl der Größe der Emitterflächen dieser Transistoren erreicht wird. Infolgedessen liefert der Transistor Q₁₃ einen Gleichstrom, der dreimal so groß ist wie der Strom, der aus dem Transistor Q₁₀ heraus fließt und somit den gesamten Versorgungsstrom des Stromspiegels 3 deckt. Über die Treiberstufe fließt dabei weiterhin nur der von dem Transistor Q₂ gelieferte Gleichstrom, so daß sich am Eingang des Differenzverstärkers kein Offset ergeben kann.

Der Basisstrom des Eingangstransistros Q₁₉ des Verstärkers 1 fließt über den Widerstand R₁. Bei der negativen Halbwelle verschiebt sich daher das Potential an der Basis von Q₁₉ entsprechend dem durch den Basisstrom hervorgerufenen Spannungsabfall an dem Widerstand R₁, Spannungsoffset von einigen Zehntel mV entspricht. Dieser unerwünschte Spannungsoffset könnte dadurch klein gehalten werden, daß der Eingangsstrom des Differenzverstärkers 1 durch eine Darlington-Konfiguration am Eingang dieses Verstärkers klein gehalten wird. Bei der Schaltung nach Fig. 2 wird ein anderer Weg beschritten.

Die Schaltung enthält zu diesem Zweck drei pnp-Transistoren Q₁, Q₃, Q₄, die mit ihren Kollektor-Emitterstrecken in Reihe zwischen Masse und die positive Versorgungsklemme geschaltet sind. Die Basis des Transistors Q₁ ist mit der Basis des Transistors Q₁₈ verbunden, so daß beide Transistoren denselben Kollektorstrom führen, der doppelt so groß ist wie der Kollektorstrom des Transistors Q₁₉. Dieser Kollektorstrom wird über den Transistor Q₃ dem Emitter des Transistors Q₄ zugeführt und über dessen Kollektor nach Masse abgeleitet. Der Basisstrom des Transistors Q₄, der doppelt so groß ist wie der Basisstrom des Transistors Q₁₉, wird über den Eingang eines Stromspiegels 8 zugeführt. Durch geeignete Wahl der Transistor-Geometrie ist dabei erreicht, daß der Ausgangsstrom dieses Stromspiegels nur halb so groß ist wie der Eingangsstrom. Dieser Ausgangsstrom wird der Basis des Transistors Q₁₉ zugeführt. Er entspricht also dem erforderlichen Basisstrom.

## Patentansprüche

1. Vollweg-Gleichrichterschaltung mit einem Signaleingang, der mit dem Signalausgang über eine Gleichrichterstufe (3, Q₁₁) gekoppelt ist, die eine bei der einen Halbschwingung vom Eingangssignalstrom durchflossene Halbleiterstrecke (Q₁₁) und einen bei der anderen Halbschwingung den Eingangsstrom zum Signalausgang spiegelnden ersten Stromspiegel (3) umfaßt, mit einem Differenzverstärker (Q₁₈...Q₂₂), dessen einer Eingang mit dem Eingang der Gleichrichterstufe gekoppelt ist und dessen Ausgang über eine Treiberstufe (Q₁₅, Q₁₆) im Sinne einer Gegerkopplung gekoppelt ist, sowie mit einer Stromquelle (4) zur Lieferung der Versorgungsströme für die Treiberstufe (Q₁₅, Q₁₆) und den ersten Stromspiegel (3),
dadurch gekennzeichnet,daß die Stromquelle (4) als steuerbare Stromquelle ausgebildet ist, die von einem aus dem Ausgangsstrom des ersten Stromspiegels (3) abgeleiteten Strom derart gesteuert wird, daß der Versorgungsstrom des ersten Stromspiegels (3) der durch die Steuerung bewirkten Stromänderung der Stromquelle (4) entspricht.

2. Schaltung nach Anspruch 1,
dadurch gekennzeichnet, daß die steuerbare Stromquelle (4) eine Konstantstromquelle (Q₂) umfaßt und den Ausgang eines zweiten Stromspiegels (Q₁₃, Q₁₄), dessen Eingang mit dem Ausgang eines dritten Stromspiegels (Q₁₂, Q₁₇) gekoppelt ist, dessen Eingang an einen Ausgang des ersten Stromspiegels (3) angeschlossen ist.

3. Schaltung nach einem der vorhergehenden Ansprüche,
dadurch gekennzeichnet, daß ein als virtueller Nullpunkt wirksamer Eingang des Differenzverstärkers (1) über einen Widerstand (R₁) mit dem Schaltungseingang (2) verbunden ist.

4. Schaltung nach einem der vorhergehenden Ansprüche,
dadurch gekennzeichnet, daß der Differenzverstärker bipolare Eingangstransistoren (A₁₉, Q₂₀) enthält, deren Basen die Eingänge des Differenzverstärkers bilden, und daß die Basis des Eingangstransistors (Q₁₉), die mit dem Schaltungseingang (2) gekoppelt ist, mit dem Ausgang eines vierten Stromspiegels (8) gekoppelt ist, dessen Eingang mit der Basis eines Transistors (Q₄) gekoppelt ist, dessen Emitterstrom proportional dem Emitterstrom des Eingangstransistors (Q₁₉) ist.

## Claims

1. A full-wave rectifier circuit having a signal input coupled to the signal output *via* a rectifier stage (3, Q₁₁), which stage comprises a semiconductor junction (Q₁₁) traversed by the input signal current during one half-wave of the current and a first current mirror (3) for reflecting the input signal current to the signal output during the other half-wave, a differential amplifier (Q₁₈... Q₂₂) having an input coupled to the input of the rectifier stage and having an output providing negative feedback *via* a driver stage (Q₁₅, Q₁₆), and a current source (4) for supplying the supply currents to the driver stage (Q₁₅, Q₁₆) and to the first current mirror (3),
characterized in that the current source (4) is constructed as a controllable current source, which is controlled by a current derived from the output current of the first current mirror (3), in such a manner that the supply current of the first current mirror (3) corresponds to the change in current of the current source (4) in response to the control action.

2. A circuit as claimed in Claim 1,
characterized in that the controllable current source (4) comprises a constant current source (Q₂) and the output of a second current mirror (Q₁₃, Q₁₄), whose input is coupled to the output of a third current mirror (Q₁₂, Q₁₇), which has its input connected to an output of the first current mirror (3).

3. A circuit as claimed in any one of the preceding Claims,
characterized in that an input of the differential amplifier (1), which acts as a virtual zero point, is connected to the signal input (2) *via* a resistor (R₁).

4. A circuit as claimed in any one of the preceding Claims,
characterized in that the differential amplifier comprises bipolar input transistors (Q₁₉, Q₂₀), whose bases constitute the inputs of the differential amplifier, and the base of the input transistor (Q₁₉), which is coupled to the signal input (2), is coupled to the output of a fourth current mirror (8), whose input is coupled to the base of a transistor (Q₄) whose emitter current is proportional to the emitter current of the input transistor (Q₁₉).

## Revendications

1. Circuit redresseur à deux alternances muni d'une entrée de signal couplée à la sortie de signal à travers a étage redresseur (3, Q₁₁) comprenant un trajet semiconducteur (Q₁₁) parcouru par le courant de signal d'entrée pendant l'une des demi-cycles et un premier miroir de courant (3) recopiant le courant d'entrée sur la sortie de signal pendant l'autre demi-cycle, d'un amplificateur différentiel (Q₁₈...Q₂₂) ayant une entrée couplée à l'entrée de l'étage redresseur et une sortie couplée en contreréaction à travers un étage pilote (Q₁₅, Q₁₆), ainsi que d'une source de courant (4) pour fournir les courants d'alimentation de l'étage pilote (Q₁₅, Q₁₆) et du premier miroir de courant (3), caractérisé en ce que la source de courant (4) est réalisée sous la forme d'une source de courant commandable, commandée par un courant déduit du courant de sortie du premier miroir de courant (3) de telle façon que le courant d'alimentation du premier miroir de courant (3) corresponde à la variation du courant de la source de courant (4), causée par la commande

2. Circuit selon la revendication 1, caractérisé en ce que la source de courant commandable (4) comporte une source de courant constant (Q₂) et la sortie d'un deuxième miroir de courant (Q₁₃, Q₁₄) ayant l'entrée couplée à la sortie d'un troisième miroir de courant (Q₁₂, Q₁₇) dont l'entrée est raccordée à la sortie du premier miroir de courant (3).

3. Circuit selon l'une quelconque des revendications précédentes, caractérisé en ce qu'une entrée de l'amplificateur différentiel (1) faisant fonction de point zéro virtuel est reliée à travers une résistance (R₁) à l'entrée (2) du circuit.

4. Circuit selon l'une des revendications précédentes, caractérisé en ce que l'amplificateur différentiel comporte des transistors bipolaires d'entrée (A₁₉), Q₂₀) dont les bases forment les entrées de l'amplificateur différentiel et que la base du transistor d'entrée (Q₁₉), couplée à l'entrée (2) du circuit, est couplée à la sortie d'un quatrième miroir de courant (8) ayant son entrée couplée à la base d'un transistor (Q₄) dont le courant d'émetteur est proportionnel au courant d'émetteur du transistor d'entrée (Q₁₉).
